Europäisches Patentamt

European Patent Office

Office européen des brevets

(19)

(11) EP 1 254 376 B1

(12) EUROPÄISCHE PATENTSCHRIFT

(45) Veröffentlichungstag und Bekanntmachung des Hinweises auf die Patenterteilung:
**20.08.2003 Patentblatt 2003/34**

(51) Int Cl.7: **G01R 19/08**

(86) Internationale Anmeldenummer:
**PCT/EP01/00539**

(21) Anmeldenummer: 01909649.4

(22) Anmeldetag: **18.01.2001**

(87) Internationale Veröffentlichungsnummer:
**WO 01/055735 (02.08.2001 Gazette 2001/31)**

(54) **VERFAHREN ZUR BESTIMMUNG DER STROMDICHTEVERTEILUNG IN EINEM BRENNSTOFFZELLENSTACK**

METHOD FOR DETECTING THE CURRENT DENSITY DISTRIBUTION IN A FUEL CELL STACK

PROCEDE POUR DETERMINER LA REPARTITION DE DENSITE DE COURANT DANS UN EMPILEMENT DE CELLULES A COMBUSTIBLE

(84) Benannte Vertragsstaaten:
**AT BE CH CY DE DK ES FI FR GB GR IE IT LI LU MC NL PT SE TR**

(30) Priorität: **28.01.2000 DE 10003584**

(43) Veröffentlichungstag der Anmeldung:
**06.11.2002 Patentblatt 2002/45**

(73) Patentinhaber: **Volkswagen Aktiengesellschaft 38436 Wolfsburg (DE)**

(72) Erfinder: **HAUER, Karl-Heinz 38442 Wolfsburg (DE)**

(56) Entgegenhaltungen:
**WO-A-99/26305**

- **WIESER ET AL.: "a new technique for two-dimensional current distribution measurements in electrochemical cells" J. OF APPLIED ELECTROHEMISTRY, Bd. 30, Nr. 7, Juli 2000 (2000-07), Seiten 803-807, XP002170127 netherlands**
- **ZTARO SOMETANI ET AL.: "eddy current measurement" JAP. JOURNAL OF APPLIED PHYSICS, Bd. 28, Nr. 1, Januar 1989 (1989-01), Seiten 112-115, XP000118534 tokyo, jp**
- **STUMPER ET AL.: "in-situ methods for the determination of current distributios in PEM fuel cells" ELECTROCHIMICA ACTA, Bd. 43, Nr. 23, 30. Juli 1998 (1998-07-30), Seiten 3773-3783, XP002170128 newcastle upon tyne, gb in der Anmeldung erwähnt**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Für den Betrieb von Brennstoffzellenstacks in Brennstoffzellensystemen, insbesondere für Brennstoffzellensysteme in Kraftfahrzeugen, ist es notwendig, die Stromdichteverteilung in den Brennstoffzellenstacks bestimmen zu können. Dabei ist es bekannt, diese Stromdichteverteilung in Brennstoffzellenstacks auf unterschiedliche Weise zu messen. In den Veröffentlichungen «In - situ methods for the determination of current distributions in PEM-fuel cells", von Jürgen Stumper, Ballard Power Systems Inc., 9000 Glenlyon Parkway, Burnaby, BC, Canada V5J 5J9, Electrochimica Acta, Vol. 43, 1998 und der Veröffentlichung «A printed circuit board approach to measuring current distribution in a fuell cell", S. J. C. Cleghorn, C. R. Derouin, M. S. Wilson, S. Gottesfeld, Los Alamos, Journal of Electrochemistry, July 1998, werden dazu entsprechende Verfahren beschrieben.

W0 99 26305 A beschreibt ein Verfahren zur Bestimmung des Stoffumsatzes bei elektrochemischen Reaktionen. Dabei wird die elektrochemische Reaktion über die hoben Ströme gemessen, die zu den Kontakt elementen führen.

Dabei weisen diese bekannten Meßverfahren zur Stromdichteverteilung in Brennstoffzellenstacks jedoch folgende Nachteile auf. Zunächst ist bei jedem dieser Meßverfahren ein Eingriff (Manipulation) in den Brennstoffzellenstack erforderlich. Daher können Meßrückwirkungen und Verfälschungen der Meßergebnisse durch diese Manipulation des Brennstoffzellenstacks nicht ausgeschlossen werden. Desweiteren muß vor der Messung und der Manipulation des Brennstoffzellenstacks festgelegt werden, an welcher Stelle der Zelle die entsprechende Stromdichteverteilung gemessen werden soll. Dabei steigt mit zunehmender Auflösung der Verdrahtungsaufwand für die Messung und begrenzt somit dessen vertretbaren Umfang. Aufgrund des Aufwandes der bekannten Messungen und der dazu erforderlichen Manipulation am Brennstoffzellenstack sind die bekannten Meßmethoden lediglich für die Forschung bzw. Entwicklung von Brennstoffzellenstacks geeignet, können jedoch zur kontinuierlichen Messung während des Betriebes oder in Serviceintervallen nicht herangezogen werden. Ein weiterer Nachteil der bekannten Meßverfahren besteht darin, daß die Variation der Stromdichteverteilung entlang des Brennstoffzellenstacks, d.h. der Variation von Zelle zu Zelle mit diesen nicht gemessen werden kann.

Der Erfindung liegt somit die Aufgabe zugrunde, ein Verfahren zur Bestimmung der Stromdichteverteilung in Brennstoffzellenstacks bereitzustellen, mit dem die Stromdichteverteilung in Brennstoffzellenstacks über den Zellenquerschnitt an beliebiger Stelle des Stacks bestimmbar ist.

Diese Aufgabe wird durch die Merkmale des Patentanspruchs 1 gelöst. Dabei wird in vorteilhafter Weise das einen stromdurchflossenen Brennstoffzellenstack umgebene Magnetfeld an mehreren Punkten gemessen und dann ausgehend von dieser Messung auf die Stromdichteverteilung über den Zellenquerschnitt im Inneren des Stacks zurückgerechnet.

Das erfindungsgemäße Verfahren zur Bestimmung der Stromdichteverteilung in Brennstoffzellenstacks durch die Messung des den Stack umgebenen magnetischen Feldes hat dabei den Vorteil, daß eine Veränderung (Manipulation) des Brennstoffzellenstacks selbst nicht erforderlich ist. Desweiteren können Meßrückwirkungen der Meßtechnik auf die Stromdichteverteilung nahezu vollständig vermieden werden. Zudem kann die Stromdichteverteilung jeder beliebigen Zelle im Stack gemessen werden, ohne daß eine Zelle vorher festgelegt werden muß. Desweiteren kann die Variation der Stromdichteverteilung entlang des Stacks (von Zelle zu Zelle) gemessen werden. Somit ist mit dem erfindungsgemäßen Meßverfahren gegenüber den bisher bekannten Verfahren eine höhere Meßgenauigkeit aufgrund höherer Auflösung bei gleichzeitig deutlich reduzierten Kosten pro Meßvorgang möglich.

Ein Ausführungsbeispiel des erfindungsgemäßen Verfahrens zur Bestimmung der Stromdichteverteilung in Brennstoffzellenstacks wird in der nachfolgenden Beschreibung und Zeichnung näher erläutert.

Dabei zeigen die

Fig. 1:   Eine schematische Darstellung der Stromlinien, des Magnetfeldes und der Sensoranordnung in einem optial arbeitenden Brennstoffzellenstack, wobei die Randeffekte vernachlässigt wurden,

Fig. 2:   zeigt die Darstellung der magnetischen Flußdichte B gemessen an diskreten Punkten auf einem Kreisbogen um die Längsachse (z) des Brennstoffzellenstacks. Die Stromdichteverteilung ist dabei homogen über den Zellquerschnitt angenomen, wobei in der Fig. 2 ein Blick auf die Stirnseite des Stacks dargestellt ist,

Fig. 3:   zeigt dementsprechend eine Darstellung der y- und z-Komponente der magnetischen Flußdichte B unter den gleichen Bedingungen wie in Fig. 2. Die Stromdichteverteilung ist dabei ebenfalls homogen über den Zellquerschnitt angenomen, wobei Fig. 3 einen Blick auf die Stimseite des Brennstoffzellenstacks zeigt,

Fig. 4:   zeigt eine Meßvorrichtungsanordnung mit mehreren Sensoren auf einem gemeinsamen Träger und

Fig. 5:   zeigt eine Meßvorrichtungsanordnung mit einem einzelnen Magnetfeld-Sensor.

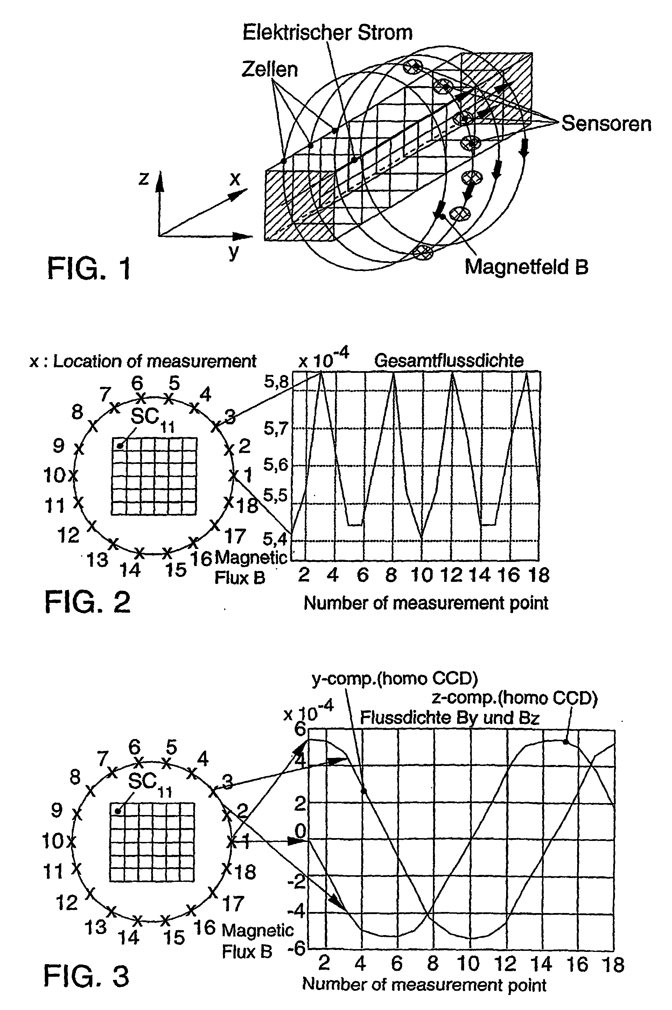

Die Erläuterung des Ausführungsbeispieles und der Darstellungen der Figuren 1 bis 5 erfolgt im Weiteren. Dabei zeigt die Fig. 1 einen Brennstoffzellenstack, der aus mehreren Einzelzellen mit Stromlinien im Inneren des Stacks besteht und ein daraus resultierendes magnetisches Feld B außerhalb des Stacks aufweist. Zur Bestimmung der Stromdichteverteilung im Stack wird das äußere Magnetfeld des zu untersuchenden Brennstoffzellenstacks in einer Ebene an der Stelle x = x0 in y- und z-Richtung gemessen (By und Bz) und auf die Stromdichteverteilung J(x0, y, z) im Inneren des Stacks zurückgeschlossen. Grundlage für die Zurückrechnung sind die Maxwellgleichung

$$\oint_{\text{Rand von A}} \vec{H} \cdot \vec{ds} = \iint_{(A)} \vec{J} \cdot \vec{dA} \qquad (1)$$

und die Materialgleichung

$$\vec{B} = \mu \cdot \vec{H} \qquad (2)$$

wobei B die magnetische Flußdichte ist, H die magnetische Feldstärke, J(x0, y, z) die Stromdichteverteilung im Inneren des Stacks an der Stelle x=x0 und A die Integrationsfläche.

Zur Bestimmung der Stromdichteverteilung an der Stelle x = x0 wird der Stack an der Stelle x = x0 geschnitten (Gedankenmodell) und die Schnittfläche in stromdurchflossene Flächeninkremente aufgeteilt. Die Gleichungen (1) und (2) werden auf jedes Flächeninkrement angewandt. Durch Überlagerung der resultierenden Einzelfelder läßt sich die Gesamtflußdichte im Raum berechnen. Diese Gesamtflußdichte wird der gemessenen Flußdichte in der Ebene x = x0 gleichgesetzt derart, daß ein lineares Gleichungssystem für die Ströme und damit die Stromdichten jedes Flächeninkremtes entsteht (Gleichung 3). Die rechte Seite des Gleichungssystems stellt dabei die magnetische Flußdichte B, gemessen in der Schnittebene, dar und kann, da durch Messung ermittelt, als bekannt vorausgesetzt werden. Die Matrix A berücksichtigt dabei den Abstand zwischen Flächeninkrement und dem Meßpunkt.

$$A(x0,y,z,y',z) \cdot \vec{J}(x0,y,z) = \vec{B}(x0,x',z') \qquad (3)$$

x0 = Schnittebene oder Messebene
y' = y Koordinate des jeweiligen Messpunktes
z' = z Koordinate des jeweiligen Messpunktes
y = y Koordinate des jeweiligen Flächenelementes
z = z Koordinate des jeweiligen Flächenelementes
$\vec{B}$ = Vektor der gemessenen Flußdichten
$\vec{J}$ = Vektor der unbekannten Stromdichten in den Flächenelementen

Der Vektor der Stromdichten und damit die Stromdichte in jedem Flächenelement und damit die Stromdichteverteilung kann durch Lösen von Gleichung (3) ermittelt werden. Die Lösung zeigt die Gleichung (4):

$$\vec{J}(x0,y,z,) = A^{-1}(x0,y,z,y',z') \cdot \vec{B}(x0,x',z') \qquad (4)$$

Die Figuren 2 und 3 zeigen beispielhaft die Verteilung der magnetischen Flußdichte um einen Stack mit beim Ausführungsbeispiel quadratischen Querschnitt durchflossen von einem Strom mit homogener Stromdichteverteilung. Die Sensoren sind in diesem Beispiel auf einem Kreisbogen um den Stack herum angeordnet. Es wird dabei auf die Stirnseite des Stacks gesehen. Fig. 2 zeigt den Absolutbetrag der magnetischen Flußdichte und Fig. 3 die y- und z-Komponente der magnetischen Flußdichte. In einem ideal arbeitenden Stack ist die Magnetfeldkomponente in x-Richtung Bx = 0. Randeffekte an Stirnseiten und Inhomogenitäten beim Zell- und Stackaufbau sowie der Gasversorgung von Anode und Kathode bedingen jedoch eine nichthomogene Stromdichteverteilung. Eine solche Verteilung führt im Stack zu Stromdichtekomponenten in y- und z-Richtung und dadurch zu einer Magnetfeldkomponente Bx in x-Richtung.

Die nachfolgenden Messungen sind mit dem erfindungsgemäßen Meßverfahren u. a. möglich:

1. Erfassung von Stellen (Zellen) mit hoher Jy- und Jz-Komponente. Dies sind Stellen an denen sich die Stromdichteverteilung Yx (x, y, z) ändert. Der Gesamtstrom ist dabei das Integral über Jx(x, y, z) und bleibt gleich. An Stellen mit hoher Jy- und Jz-Komponente existiert eine Magnetfeldkomponente Bx (x) ungleich 0. In Schritt 1 wird der Magnetsensor entlang der x-Achse (Koordinaten siehe Fig. 1) geführt und die Magnetfeldkomponente $B_x$ gemessen. Eine $B_x$-Komponente des äußeren Magnetfeldes ist dann ein Hinweis auf die Stromdichtekomponenten Jy und Jz in y- und z-Richtung, also ein Hinweis darauf, daß sich die Stromdichteverteilung Jx (x, y, z) ändert. Der Gradient der Flußdichte Bx in x-Richtung ist ein Maß für die Stärke der Änderung von Jx(x, y, z).

2. Erfassung der Stromdichteverteilung Jx(x0, y, z) über den Zellquerschnitt A an der Stelle x = x0. Hierzu werden die Magnetfeldkomponenten By und Bz an der Stelle x = x0 an mehreren Punkten am Umfang in der Ebene x = x0 gemessen.

Die Anzahl der Meßpunkte N hängt von der benötigten Stromdichteauflösung ab und ist mindestens:
N = 0,5 mal Anzahl der Flächenquadrate in die der Stackquerschnitt (entspricht Zellquerschnitt) aufgeteilt wird, wenn die Flußdichte By und Bz gemessen wird.

Wird nur eine Komponente der Flußdichte gemessen (By oder Bz) ist die Anzahl der Meßpunkte N = der Anzahl der Flächenquadrate in die der Stackquerschnitt (entspricht Zellquerschnitt) aufgeteilt wird. Die Anzahl der Meßwerte N kann aber auch größer als die Mindestanzahl sein. Mit diesen Meßwerten der magnetischen Flußdichte (By, Bz) zusammen mit der Position an der sie gemessen wurden (x = x0, y, z) kann dann auf die Stromdichteverteilung an der Stelle x = x0 im Inneren des Stacks zurückgeschlossen werden. Dazu müssen die Gleichungen 1 und 2 in diskreter Form für die Stromdichte J gelöst werden. Eine Matrixinversion (nach Gleichung 4) ist dafür erforderlich.

Im folgenden soll ein Meßbeispiel näher erläutert werden. Eine Erfassung der Stromdichte in der Ebene x = x0 unter der Annahme, daß 100 Flächenquadrate aufgelöst werden sollen, bedeutet, daß 100 unbekannte Stromdichten zu berechnen sind. Dabei weist jedes Flächenquadrat seine eigene Stromdichte auf. Es wird ein lineares Gleichungssystem mit 100 Gleichungen benötigt. Zur Aufstellung dieses Gleichungssystems müssen 50 Flußdichten in der Ebene x = x0 einschließlich ihrer Position relativ zum Stack aufgenommen werden. Diese 50 Meßpunkte beinhalten 50 Flußdichtepaare (By, Bz), die dann zur Aufstellung des Gleichungssystems für die Stromdichte J (x0, y, z) verwendet werden. Die Lösung dieses linearen Gleichungssystems führt dann zu der Stromdichteverteilung J (x0, y, z).

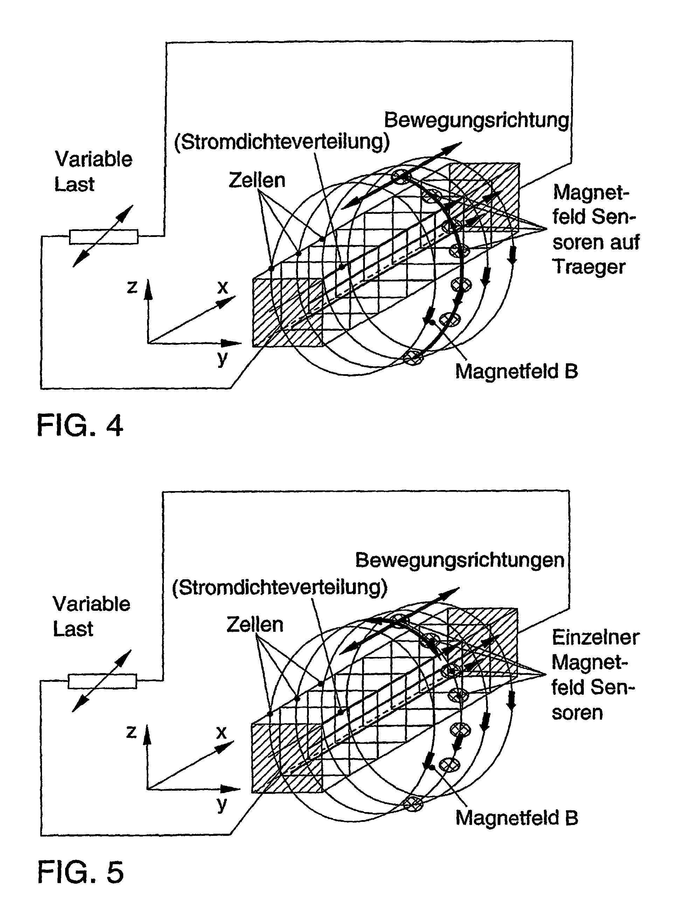

Dabei ist es besonders vorteilhaft, wenn wie in der Figur 5 dargestellt, die Aufnahme der Meßpunkte sequentiell erfolgt, wobei mit einem einzigen Sensor für die Flußdichte und einem weiteren Sensor für die Position des Flußdichtesensors die verschiedenen Meßpunkte nacheinander angefahren werden und die Messungen zeitlich hintereinander durchgeführt werden.

Bei einer weiteren vorteilhaften in der Figur 4 dargestellten Variante erfolgt die Aufnahme der Meßpunkte parallel, wobei mehrere Sensoren für die Flußdichte und Position vorgesehen sind und alle Meßwerte zeitlich gleichzeitig erfaßt werden.

Die Aufnahme der Meßpunkte kann dabei mit mehreren Sensoren parallel und zusätzlich gleichzeitig sequentiell erfolgen, wobei eine Anzahl von Meßwerten parallel erfaßt wird und dann die Sensoren neu positioniert werden und ein weiterer Satz von Meßwerten erfaßt wird.

Alternativ kann ein Positionssensor durch einen Mechanismus ersetzt werden, wobei eine Vorrichtung zur Ursprungserkennung vorgesehen ist, die mit einem Algorithmus zum Zählen von Schritten in einer Positionierungseinrichtung mit festen Inkrementen (Schrittmotor) kombiniert ist, wobei die Angabe der Position dabei vorzugsweise relativ zu einem Referenzpunkt (Ursprung) erfolgt.

Bei einer Parallelmessung mit mehreren Sensoren sind diese vorteilhafterweise relativ zueinander räumlich fest angeordnet, vorzugsweise auf einem gemeinsamen Träger, und können dann gemeinsam vorzugsweise in Hauptrichtung x des Brennstoffzellenstacks positioniert werden (Fig. 4).

Der Abstand der Flußdichtesensoren vom Stack kann variiert werden, um so den Meßbereich der Sensoren an die Flußdichte außerhalb des Stacks anpassen zu können.

Die Sensoren der Meßanordnung können alle in einer Ebene, vorzugsweise x = x0 angeordnet sein.

Die Komponente Bx des Magnetfeldes wird vorzugsweise zur Erkennung von Stellen, an denen sich die Stromdichteverteilung ändert ausgewertet.

Es können alternativ Sensoren eingesetzt werden, die alle drei Flußdichtekomponenten (Bx, By, Bz) messen.

Die eingesetzten Sensoren können aber auch jeweils nur eine Komponente (Bx, By oder Bz) erfassen.

Es können getrennte Sensoren für die Feldkomponente (Bx) und die Feldkomponenten (By und Bz) verwendet werden.

Es können mehr Meßwerte als für die gewünschte Auflösung der Stromdichte notwendig ist, erfaßt werden.

Es können alternativ für die Berechnung der Gleichungssysteme für die Stromdichteverteilung iterative Rechenverfahren eingesetzt werden.

Es können alternativ oder ergänzend zur Lösung der Gleichungssysteme für die Stromdichtewerte Vergleiche mit Magnetfeldern von Brennstoffzellenstacks mit bekannter Stromdichteverteilung durchgeführt werden und mit diesen Ergebnissen auf die Stromdichteverteilung am zu ermessenden Brennstoffzellenstack zurückgeschlossen werden.

Zur Lösung des Gleichungssystems für die Berechnung der Stromdichtewerte kann ein Montecarlo-Algorithmus eingesetzt werden derart, daß Stromdichteverteilungen angenommen werden, das resultierende Feld berechnet wird und dann mit dem gemessenen Feld verglichen wird, wobei in einer nächsten Iterationsschleife dann diese angenommene Stromdichteverteilung korrigiert wird, derart daß die Unterschiede zwischen berechnetem und gemessenem Feld kleiner werden, wobei bei genügend großer Korrelation zwischen berechnetem und gemessenem Feld das Verfahren abgebrochen wird und die angenommene Stromdichteverteilung das Ergebnis darstellt.

Durch die Erhöhung der Meßwertezahl für die Flußdichte und Position kann das Meßergebnis hinsichtlich der Auflösung der Stromdichteverteilung präzisiert werden.

In einer der eigentlichen Messung vorangehenden Messung kann zudem das Erdmagnetfeld gemessen und diese Werte von der eigentlichen Messung abgezogen werden.

Der Brennstoffzellenstrom kann alternativ niederfrequent moduliert und mit einer entsprechenden Hardware und/oder Softwarefiltern für die Flußdichtemessungen der Einfluß des quasistatischen Erdmagnetfeldes auf das Meßergebnis unterdrückt werden.

Sämtliche Meßwerte (Position, Magnetfeld, Stromfluß) können in ein elektronisches Meßverarbeitungssystem (Computer) eingeleitet werden, wobei dann dort die Stromdichteverteilung automatisch berechnet, abgespeichert und mit früheren Messungen verglichen wird.

Mit dem erfindungsgemäßen Meßverfahren kann auch die magnetische Feldstärke (H) des vom Stromfluß im Stack erzeugten Magnetfeldes (B) gemessen werden.

Es ist zudem möglich, die Messung in zwei Teilmessungen zu unterteilen, wobei in einem ersten Teilmeßvorgang der gesamte Stack mit einer groben Auflösung abgescannt wird und dann in einem zweiten Teilmeßvorgang die kritischen Bereiche mit höherer Auflösung untersucht werden.

## Patentansprüche

1. Verfahren zur Bestimmung der Stromdichteverteilung $J_{xyz}$ (x, y, z) in einem Brennstoffzellenstack, **dadurch gekennzeichnet, daß** die Stromdichteverteilung aus dem den Stack umgebenen, vom Stromfluß im Stack erzeugten Magnetfeld bestimmt wird.

2. Verfahren zur Bestimmung der Stromdichteverteilung in einem Brennstoffzellenstack nach Anspruch 1, **dadurch gekennzeichnet, daß** Sensoren für die x-, y- und z-Komponente der magnetischen Flußdichte diese an mehreren Punkten außerhalb des Stacks erfassen, die Position der Sensoren für die Flußdichte relativ zum Stack bestimmt wird und diese Werte für Flußdichte und zugeordnete Position mit Hilfe der Maxweilgleichung, die die magnetische Feldstärke definiert, und der Materialgleichung, die die magnetische Feldstärke und Flußdichte in Beziehung setzt, in Stromdichtewerte in Abhängigkeit von der Position im Stack umgerechnet werden.

3. Verfahren zur Bestimmung der Stromdichteverteilung in einem Brennstoffzellenstack nach Anspruch 2, **dadurch gekennzeichnet, daß** die Aufnahme der Meßpunkte sequentiell erfolgt, wobei mit einem einzigen Sensor für die Flußdichte und einem weiteren Sensor für die Position des Flußdichtesensors die verschiedenen Meßpunkte nacheinander angefahren werden und die Messungen zeitlich hintereinander durchgeführt werden.

4. Verfahren zur Bestimmung der Stromdichteverteilung in einem Brennstoffzellenstack nach Anspruch 2, **dadurch gekennzeichnet, daß** die Aufnahme der Meßpunkte parallel erfolgt, wobei mehrere Sensoren für die Flußdichte und Position vorgesehen sind und alle Meßwerte zeitlich gleichzeitig erfaßt werden.

5. Verfahren zur Bestimmung der Stromdichteverteilung in einem Brennstoffzellenstack nach Anspruch 2, **dadurch gekennzeichnet, daß** die Aufnahme der Meßpunkte mit mehreren Sensoren parallel und zusätzlich gleichzeitig sequentiell erfolgt, wobei eine Anzahl von Meßwerten parallel erfaßt wird und dann die Sensoren neu positioniert werden und ein weiterer Satz von Meßwerten erfaßt wird.

6. Verfahren zur Bestimmung der Stromdichteverteilung in einem Brennstoffzellenstack nach Anspruch 2, **dadurch gekennzeichnet, daß** ein Positionssensor durch einen Mechanismus ersetzt wird, wobei eine Vorrichtung zur Ursprungserkennung vorgesehen ist, die mit einem Algorithmus zum Zählen von Schritten in einer Positionierungseinrichtung mit festen Inkrementen kombiniert ist, wobei die Angabe der Position dabei vorzugsweise relativ zu einem Referenzpunkt erfolgt.

7. Verfahren zur Bestimmung der Stromdichteverteilung in einem Brennstoffzellenstack nach Anspruch 2, **dadurch gekennzeichnet, daß** bei einer Parallelmessung mit mehreren Sensoren diese relativ zueinander räumlich fest angeordnet sind, vorzugsweise auf einem gemeinsamen Träger, und dann gemeinsam vorzugsweise in Hauptrichtung x des Brennstoffzellenstacks positioniert werden.

8. Verfahren zur Bestimmung der Stromdichteverteilung in einem Brennstoffzellenstack nach Anspruch 2, **dadurch gekennzeichnet, daß** der Abstand der Flußdichtesensoren vom Stack variiert wird, um so den Meßbereich der Sensoren an die Flußdichte außerhalb des Stacks anpassen zu können.

9. Verfahren zur Bestimmung der Stromdichteverteilung in einem Brennstoffzellenstack nach Anspruch 2, **dadurch gekennzeichnet, daß** die Sensoren alle in einer Ebene, vorzugsweise x = x0 angeordnet sind.

10. Verfahren zur Bestimmung der Stromdichteverteilung in einem Brennstoffzellenstack nach Anspruch 2, **dadurch gekennzeichnet, daß** die Komponente Bx des Magnetfeldes zur Erkennung von Stellen, an denen sich die Stromdichteverteilung ändert, ausgewertet wird.

11. Verfahren zur Bestimmung der Stromdichteverteilung in einem Brennstoffzellenstack nach Anspruch 2, **dadurch gekennzeichnet, daß** Sensoren eingesetzt werden, die alle drei Flußdichtekomponenten (Bx, By, Bz) messen.

12. Verfahren zur Bestimmung der Stromdichteverteilung in einem Brennstoffzellenstack nach Anspruch 2, **dadurch gekennzeichnet, daß** die eingesetzten Sensoren jeweils nur eine Komponente (Bx, By oder Bz) erfassen.

13. Verfahren zur Bestimmung der Stromdichteverteilung in einem Brennstaffzellenstack nach Anspruch 2, **dadurch gekennzeichnet, daß** getrennte Sensoren für die Feldkomponente (Bx) und die Feldkomponenten (By und Bz) verwendet werden.

14. Verfahren zur Bestimmung der Stromdichteverteilung in einem Brennstoffzellenstack nach Anspruch 2, **dadurch gekennzeichnet, daß** mehr Meßwerte als für die gewünschte Auflösung der Stromdichte notwendig ist, erfaßt werden.

15. Verfahren zur Bestimmung der Stromdichteverteilung in einem Brennstoffzellenstack nach Anspruch 2, **dadurch gekennzeichnet, daß** für die Berechnung der Gleichungssysteme für die Stromdichteverteilung iterative Rechenverfahren eingesetzt werden.

16. Verfahren zur Bestimmung der Stromdichteverteilung in einem Brennstoffzellenstack nach Anspruch 2, **dadurch gekennzeichnet, daß** alternativ oder ergänzend zur Lösung der Gleichungssysteme für die Stromdichtewerte Vergleiche mit Magnetfeldern von Brennstoffzellenstacks mit bekannter Stromdichteverteilung durchgeführt werden und mit diesen Ergebnissen auf die Stromdichteverteilung am zu messenden Brennstoffzellenstack zurückgeschlossen wird.

17. Verfahren zur Bestimmung der Stromdichteverteilung in einem Brennstoffzellenstack nach Anspruch 2, **dadurch gekennzeichnet, daß** zur Lösung des Gleichungssystems für die Berechnung der Stromdichtewerte ein Montecarlo-Algorithmus eingesetzt wird derart, daß Stromdichteverteilungen angenommen werden, das resultierende Feld berechnet wird und dann mit dem gemessenen Feld verglichen wird, wobei in einer nächsten Iterationsschleife dann diese angenommene Stromdichteverteilung korrigiert wird, derart daß die Unterschiede zwischen berechnetem und gemessenem Feld kleiner werden, wobei bei genügend großer Korrelation zwischen berechnetem und gemessenem Feld das Verfahren abgebrochen wird und die angenommene Stromdichteverteilung das Ergebnis darstellt.

18. Verfahren zur Bestimmung der Stromdichteverteilung in einem Brennstoffzellenstack nach Anspruch 2, **dadurch gekennzeichnet, daß** durch die Erhöhung der Meßwertezahl für die Flußdichte und Position das Meßergebnis hinsichtlich der Auflösung der Stromdichteverteilung präzisiert wird.

19. Verfahren zur Bestimmung der Stromdichteverteilung in einem Brennstoffzellenstack nach Anspruch 2, **dadurch gekennzeichnet, daß** in einer der eigentlichen Messung vorangehenden Messung das Erdmagnetfeld gemessen wird und diese Werte von der eigentlichen Messung abgezogen werden.

20. Verfahren zur Bestimmung der Stromdichteverteilung in einem Brennstoffzellenstack nach Anspruch 2, **dadurch gekennzeichnet, daß** der Brennstoffzellenstrom niederfrequent moduliert wird und mit einer entsprechenden Hardware und/oder Softwarefiltern für die Flußdichtemessungen der Einfluß des quasistatischen Erdmagnetfeldes auf das Meßergebnis unterdrückt wird.

**21.** Verfahren zur Bestimmung der Stromdichteverteilung in einem Brennstoffzellenstack nach Anspruch 2, **dadurch gekennzeichnet, daß** sämtliche Meßwerte in ein elektronisches Meßverarbeitungssystem eingeleitet werden und dann dort die Stromdichteverteilung automatisch berechnet, abgespeichert und mit früheren Messungen verglichen wird.

**22.** Verfahren zur Bestimmung der Stramdichteverteilung in einem Brennstoffzellenstack nach Anspruch 2, **dadurch gekennzeichnet, daß** die magnetische Feldstärke (H) des vom Stromfluß im Stack erzeugten Magnetfeldes (B) gemessen wird.

**23.** Verfahren zur Bestimmung der Stromdichteverteilung in einem Brennstoffzellenstack nach Anspruch 2, **dadurch gekennzeichnet, daß** die Messung in zwei Teilmessungen unterteilt wird, wobei in einem ersten Teilmeßvorgang der gesamte Stack mit einer groben Auflösung abgescannt wird und dann in einem zweiten Teilmeßvorgang die kritischen Bereiche mit höherer Auflösung untersucht werden.

## Claims

**1.** Method for determination of the current density distribution $J_{xyz}$ (x, y, z) in a fuel cell stack, **characterized in that** the current density distribution is determined from the magnetic field which surrounds the stack and is produced by the current flow in the stack.

**2.** Method for determination of the current density distribution in a fuel cell stack according to Claim 1, **characterized in that** sensors for the x, y and z components of the magnetic flux density detect these components at a number of points outside the stack, the position of the sensors for the flux density is determined relative to the stack, and these values for the flux density and the associated position are converted to current density values as a function of the position in the stack, with the aid of Maxwell's equation, which defines the magnetic field strength, and the material equation, which relates the magnetic field strength and the flux density.

**3.** Method for determination of the current density distribution in a fuel cell stack according to Claim 2, **characterized in that** the measurement points are recorded sequentially, with the various measurement points being moved to successively and the measurements being carried out successively in time, with a single sensor for the flux density and a further sensor for the position of the flux density sensor.

**4.** Method for determination of the current density distribution in a fuel cell stack according to Claim 2, **characterized in that** the measurement points are recorded in parallel, with a number of sensors being provided for the flux density and position, and all the measurement values being detected at the same time.

**5.** Method for determination of the current density distribution in a fuel cell stack according to Claim 2, **characterized in that** the measurement points are recorded with a number of sensors in parallel and in addition sequentially at the same time, with a number of measurement values being detected in parallel and the sensors then being repositioned and a further set of measurement values being detected.

**6.** Method for determination of the current density distribution in a fuel cell stack according to Claim 2, **characterized in that** a position sensor is replaced by a mechanism, with an apparatus being provided for origin identification, which is combined with an algorithm for counting steps in a positioning device with fixed increments, with the position in this case preferably being indicated relative to a reference point.

**7.** Method for determination of the current density distribution in a fuel cell stack according to Claim 2, **characterized in that**, when a parallel measurement is carried out with a number of sensors, these sensors are arranged such that they are spatially fixed relative to one another, preferably on a common mount, and are then positioned, preferably jointly, in the main direction x of the fuel cell stack.

**8.** Method for determination of the current density distribution in a fuel cell stack according to Claim 2, **characterized in that** the distance between the flux density sensors and the stack is varied in order in this way to make it possible to match the measurement range of the sensors to the flux density outside the stack.

9. Method for determination of the current density distribution in a fuel cell stack according to Claim 2, **characterized in that** the sensors are all arranged in one plane, preferably x = x0.

10. Method for determination of the current density distribution in a fuel cell stack according to Claim 2, **characterized in that** the component Bx of the magnetic field is evaluated in order to identify points at which the current density distribution changes.

11. Method for determination of the current density distribution in a fuel cell stack according to Claim 2, **characterized in that** sensors are used which measure all three flux density components (Bx, By, Bz).

12. Method for determination of the current density distribution in a fuel cell stack according to Claim 2, **characterized in that** the sensors which are used each detect only one component (Bx, By or Bz).

13. Method for determination of the current density distribution in a fuel cell stack according to Claim 2, **characterized in that** separate sensors are used for the field component (Bx) and for the field components (By and Bz).

14. Method for determination of the current density distribution in a fuel cell stack according to Claim 2, **characterized in that** more measurement values are detected than is necessary for the desired resolution of the current density.

15. Method for determination of the current density distribution in a fuel cell stack according to Claim 2, **characterized in that** iterative calculation methods are used for the calculation of the equation systems for the current density distribution.

16. Method for determination of the current density distribution in a fuel cell stack according to Claim 2, **characterized in that**, alternatively or in addition to the solution of the equation system for the current density values, comparisons are carried out with magnetic fields from fuel cell stacks with a known current density distribution, and these results are used to deduce the current density distribution on the fuel cell stack which is to be measured.

17. Method for determination of the current density distribution in a fuel cell stack according to Claim 2, **characterized in that** a Monte Carlo algorithm is used for the calculation of the current density values in order to solve the equation system, such that current density distributions are assumed, the resultant field is calculated and is then compared with the measured field, with this assumed current density distribution then being corrected in a next iteration loop, such that the differences between the calculated field and the measured field become smaller, with the method being terminated when the correlation between the calculated field and the measured field is sufficiently high, and the assumed current density distribution representing the result.

18. Method for determination of the current density distribution in a fuel cell stack according to Claim 2, **characterized in that** the measurement result is made more precise with respect to the resolution of the current density distribution by increasing the number of measurement values for the flux density and position.

19. Method for determination of the current density distribution in a fuel cell stack according to Claim 2, **characterized in that** the earth's magnetic field is measured in a measurement which is carried out before the actual measurement, and these values are subtracted from the actual measurement.

20. Method for determination of the current density distribution in a fuel cell stack according to Claim 2, **characterized in that** the fuel cell current is modulated at a low frequency, and the influence of the quasi-static earth's magnetic field on the measurement result is suppressed by means of appropriate hardware and/or software filters for the flux density measurements.

21. Method for determination of the current density distribution in a fuel cell stack according to Claim 2, **characterized in that** all the measurement values are introduced into an electronic measurement processing system, where the current density distribution is then automatically calculated, stored and compared with earlier measurements, there.

22. Method for determination of the current density distribution in a fuel cell stack according to Claim 2, **characterized in that** the magnetic field strength (H) of the magnetic field (B) which is produced by the current flow in the stack is measured.

23. Method for determination of the current density distribution in a fuel cell stack according to Claim 2, **characterized**

**in that** the measurement process is subdivided into two measurement elements, with the entire stack being scanned with coarse resolution in a first measurement element process, and the critical areas then being investigated with higher resolution in a second measurement element process.

**Revendications**

1. Procédé pour la détermination de la répartition des densités de courant $J_{xyz}$ (x, y, z) dans un empilement de cellules à combustible, **caractérisé en ce que** la répartition des densités de courant est déterminée à partir du champ magnétique qui entoure l'empilement et qui est créé par l'écoulement du courant dans l'empilement.

2. Procédé pour la détermination de la répartition des densités de courant dans un empilement de cellules à combustible selon la revendication 1, **caractérisé en ce que** des capteurs des composantes x, y et z de la densité de flux magnétique détectent celles-ci en plusieurs points situés à l'extérieur de l'empilement, la position des capteurs de densité de flux par rapport à l'empilement étant déterminée et ces valeurs de la densité de flux et de la position associée étant converties en valeurs de densité de courant en fonction de la position dans l'empilement à l'aide de l'équation de Maxwell qui définit l'intensité du champ magnétique et de l'équation de matière qui relie l'intensité du champ magnétique et la densité de flux.

3. Procédé pour la détermination de la répartition des densités de courant dans un empilement de cellules à combustible selon la revendication 2, **caractérisé en ce que** l'enregistrement des points de mesure s'effectue séquentiellement, les différents points de mesure étant activés successivement à l'aide d'un unique capteur de densité de flux et d'un autre capteur de position du capteur de densité de flux, et les mesures étant exécutées successivement.

4. Procédé pour la détermination de la répartition des densités de courant dans un empilement de cellules à combustible selon la revendication 2, **caractérisé en ce que** l'enregistrement des points de mesure s'effectue en parallèle, plusieurs capteurs de densité de flux et de position étant prévus et toutes les valeurs de mesure étant saisies simultanément.

5. Procédé pour la détermination de la répartition des densités de courant dans un empilement de cellules à combustible selon la revendication 2, **caractérisé en ce que** l'enregistrement des points de mesure s'effectue en parallèle avec plusieurs capteurs et en outre en même temps successivement, un certain nombre de valeurs de mesure étant détectées en parallèle, les capteurs étant ensuite placés dans une nouvelle position et un autre jeu de valeurs de mesure étant détectées.

6. Procédé pour la détermination de la répartition des densités de courant dans un empilement de cellules à combustible selon la revendication 2, **caractérisé en ce qu'**un capteur de position est remplacé par un mécanisme, un dispositif de détection de l'origine étant prévu et étant combiné avec un algorithme à incréments fixes de comptage des pas d'un dispositif de positionnement, les données de position étant fournies de préférence par rapport à un point de référence.

7. Procédé pour la détermination de la répartition des densités de courant dans un empilement de cellules à combustible selon la revendication 2, **caractérisé en ce qu'**en cas de mesure en parallèle avec plusieurs capteurs, ces derniers sont disposés dans l'espace en positions fixes les unes par rapport aux autres, de préférence sur un support commun, et étant alors positionnés tous de préférence dans la direction principale x de l'empilement de cellules à combustible.

8. Procédé pour la détermination de la répartition des densités de courant dans un empilement de cellules à combustible selon la revendication 2, **caractérisé en ce que** la distance entre les capteurs de densité de flux par rapport à l'empilement est modifiée pour ainsi pouvoir adapter la plage de mesure des capteurs à la densité de flux à l'extérieur de l'empilement.

9. Procédé pour la détermination de la répartition des densités de courant dans un empilement de cellules à combustible selon la revendication 2, **caractérisé en ce que** les capteurs sont tous disposés dans un plan, de préférence x = x0.

10. Procédé pour la détermination de la répartition des densités de courant dans un empilement de cellules à combustible selon la revendication 2, **caractérisé en ce que** la composante Bx du champ magnétique est évaluée pour détecter les emplacements auxquels la répartition des densités de courant se modifie.

11. Procédé pour la détermination de la répartition des densités de courant dans un empilement de cellules à combustible selon la revendication 2, **caractérisé en ce que** l'on utilise des capteurs qui mesurent les trois composantes (Bx, By, Bz) de la densité de flux.

12. Procédé pour la détermination de la répartition des densités de courant dans un empilement de cellules à combustible selon la revendication 2, **caractérisé en ce que** les capteurs utilisés ne détectent chacun qu'une seule composante (Bx, By ou Bz).

13. Procédé pour la détermination de la répartition des densités de courant dans un empilement de cellules à combustible selon la revendication 2, **caractérisé en ce que** l'on utilise des capteurs distincts pour la composante (Bx) du champ et les composants (By et Bz) du champ.

14. Procédé pour la détermination de la répartition des densités de courant dans un empilement de cellules à combustible selon la revendication 2, **caractérisé en ce que** l'on saisit un plus grand nombre de valeurs de mesure que celui nécessaire pour la résolution souhaitée des densités de courant.

15. Procédé pour la détermination de la répartition des densités de courant dans un empilement de cellules à combustible selon la revendication 2, **caractérisé en ce que** l'on utilise un procédé de calcul itératif pour les systèmes d'équations de la répartition des densités de courant.

16. Procédé pour la détermination de la répartition des densités de courant dans un empilement de cellules à combustible selon la revendication 2, **caractérisé en ce qu'**en variante ou en complément, pour la solution des systèmes d'équations des valeurs de densité de courant, on effectue des comparaisons avec des champs magnétiques d'empilements de cellules à combustible dont la répartition des densités de courant est connue, et que l'on utilise ces résultats pour déterminer la répartition des densités de courant de l'empilement de cellules à combustible à mesurer.

17. Procédé pour la détermination de la répartition des densités de courant dans un empilement de cellules à combustible selon la revendication 2, **caractérisé en ce que** pour résoudre le système d'équations pour le calcul des valeurs de densité de courant, on utilise un algorithme de Montecarlo par lequel les répartitions de densité de courant sont enregistrées, le champ résultant est calculé et est comparé ensuite au champ mesuré, tandis que dans une boucle d'itération suivante, cette répartition des densités de courant enregistrée est corrigée de telle sorte que les différences entre le champ calculé et le champ mesuré soient diminuées, et si la corrélation entre le champ calculé et le champ mesuré est suffisamment grande, l'opération est interrompue et la répartition des densités de courant enregistrée représente le résultat.

18. Procédé pour la détermination de la répartition des densités de courant dans un empilement de cellules à combustible selon la revendication 2, **caractérisé en ce que** l'on précise la résolution de la répartition des densités de courant par l'augmentation du nombre des valeurs de mesure de la densité de flux et de la position du résultat de mesure.

19. Procédé pour la détermination de la répartition des densités de courant dans un empilement de cellules à combustible selon la revendication 2, **caractérisé en ce que** le champ magnétique terrestre est mesuré pendant une mesure qui précède la mesure proprement dite, ces valeurs étant soustraites de la mesure proprement dite.

20. Procédé pour la détermination de la répartition des densités de courant dans un empilement de cellules à combustible selon la revendication 2, **caractérisé en ce que** le courant dans les cellules à combustible est modulé à basse fréquence, et l'influence du champ magnétique quasi statique sur le résultat de la mesure est diminué à l'aide de filtres électroniques et/ou logiciels appropriés utilisés sur les mesures de densité de flux.

21. Procédé pour la détermination de la répartition des densités de courant dans un empilement de cellules à combustible selon la revendication 2, **caractérisé en ce que** toutes les valeurs de mesure sont délivrées à un système électronique de traitement des mesures dans lequel la répartition des densités de courant est calculée automatiquement, conservée en mémoire et comparée à des mesures précédentes.

**22.** Procédé pour la détermination de la répartition des densités de courant dans un empilement de cellules à combustible selon la revendication 2, **caractérisé en ce que** l'on mesure l'intensité (H) du champ magnétique (B) qui est créé par le courant qui s'écoule dans l'empilement.

**23.** Procédé pour la détermination de la répartition des densités de courant dans un empilement de cellules à combustible selon la revendication 2, **caractérisé en ce que** la mesure est divisée en deux mesures partielles, l'ensemble de l'empilement étant balayé avec une résolution grossière dans une première opération de mesure partielle, les régions critiques étant ensuite étudiées avec une résolution plus élevée dans une deuxième opération de mesure partielle.

FIG. 1

FIG. 2

FIG. 3

FIG. 4

FIG. 5